# EUROPÄISCHE PATENTANMELDUNG

(11) **EP 3 110 173 A1**
(43) Veröffentlichungstag der Anmeldung: **28.12.2016**
(21) Anmeldenummer: 16172311.9
(22) Anmeldetag: 31.05.2016
(51) Int. Cl.: H04R 25/00, H03G 7/00, H03G 9/02

(54) **VERFAHREN ZUR KOMPRESSION DER DYNAMIK IN EINEM AUDIO-SIGNAL**

(30) Priorität: 24.06.2015 DE 102015211745
(71) Anmelder: Sivantos Pte. Ltd., Singapore 139959 (SG)
(72) Erfinder: PETRAUSCH, Stefan, 91056 Erlangen (DE); GIESE, Ulrich, 90765 Erlangen (DE); PAPE, Sebastian, 91054 Erlangen (DE)
(74) Vertreter: FDST Patentanwälte

(57) **Zusammenfassung**

Die Erfindung nennt ein Verfahren (1) zur Kompression der Dynamik in einem Audio-Signal (6), wobei wenigstens ein Eingangspegel (12) des Audio-Signals (6) gemessen wird, wobei der gemessene Eingangspegel (12) mit einem Grenzwert (16) verglichen wird, wobei eine vorgegebene Kompressionscharakteristik (18) mit einem durch einen Basiswert (28) des Eingangspegels (12) definierten Kniepunkt (30) an das Audio-Signal (6) angepasst wird, indem der Kniepunkt (30) vom Basiswert (28) auf einen höheren Zielwert (32) angehoben wird, wenn der wenigstens eine Eingangspegel (12) den Grenzwert (16) überschreitet, und wobei das Audio-Signal (6) gemäß der angepassten Kompressionscharakteristik (22) komprimiert wird. Die Erfindung nennt weiter eine Signalverarbeitungseinheit (38), umfassend einen Signaleingang zur Einspeisung eines Audio-Signals (6), welche dazu eingerichtet ist, ein solches Verfahren (1) durchzuführen, sowie ein Hörgerät (35), mit wenigstens einem Mikrofon (2) zur Gewinnung eines Audio-Signals (6) aus einem Umgebungsschall (4), und einer mit dem Mikrofon (2) verbundenen derartigen Signalverarbeitungseinheit (38).

## Beschreibung

Die Erfindung betrifft ein Verfahren zur Kompression der Dynamik in einem Audio-Signal, welches beispielsweise aus einem Umgebungsschall gewonnen wird oder von einer Audioquelle eingespeist wird. Das Audiosignal ist hierbei das Signal, aus welchem für einen Nutzer ein Hörsignal generiert wird.

In der Signalverarbeitung eines Audio-Signals stellt die Kompression der Dynamik oftmals ein wichtiges Hilfsmittel dar, ein Schallsignal mit großen Pegeldifferenzen, und somit einem großen Dynamikumfang, adäquat abbilden zu können. Große Differenzen im Pegel des aufzuzeichnenden und zu verarbeitenden Schallsignals können bei einer rein linearen Verstärkung des Audio-Signals dazu führen, dass entweder bei einem zu groß gewählten Verstärkungsfaktor die Signalanteile mit den größten Pegelausschlägen an einem Punkt der Signalverarbeitung zu einem Übersteuern führen, oder bei einem zu klein gewählten Verstärkungsfaktor Signalanteile mit einem niedrigen Signalpegel keinen befriedigenden, insbesondere keinen ausreichend hörbaren Eingang in ein fertig verarbeitetes Ausgangssignal finden.

Im Bereich der Hörgeräte stellt die Kompression der Dynamik eine Möglichkeit dar, das Hörsignal an das eingeschränkte Hörvermögen eines Hörgeschädigten anzupassen. Das Hörvermögen eines Hörgeschädigten weist einen eingeschränkten Dynamikbereich auf, so dass kleine Eingangspegel viel verstärkt werden müssen. Für große Eingangspegel muss jedoch die Verstärkung abgesenkt werden, weil die derart verstärkten Hörsignale sonst als unangenehm laut empfunden werden.

Die Kompression der Dynamik des Audio-Signals tritt dem hierbei durch eine Verstärkung mit einem pegelabhängigen Verstärkungsfaktor entgegen. In den meisten Fällen weist dabei die Kompressionscharakteristik, dargestellt durch die Kennlinie, welche das Verhältnis von Eingangspegel zu Ausgangspegel angibt, eine bis zu einem bestimmten Schwellwert des Eingangspegels lineare Verstärkung um einen konstanten Faktor auf, während für Eingangspegel jenseits des Schwellwerts die Verstärkung pegelabhängig gesenkt wird. Trägt man Eingangspegel und Ausgangspegel in Dezibel gegeneinander auf, so ergibt sich hierdurch als Kompressionscharakteristik ein streckenweise linearer Verlauf, wobei die Kennlinie ab dem Schwellwert für den Eingangspegel eine geringere Steigung aufweist. Die Abweichung dieser Steigung von einem diagonalen Verlauf bestimmt dabei das Kompressionsverhältnis r < 1, um welches der Eingangspegel jenseits des Schwellwerts komprimiert wird.

In einer lauten Umgebung, deren durchschnittlicher Schallpegel einen entsprechenden Signalpegel aufweist, welcher nahe diesem Schwellwert liegt, neigen Sprecher meist dazu, auf den höheren Geräuschpegel in der Umgebung durch ein lauteres Sprechen zu reagieren. Für eine Kompression der Dynamik, deren Schwellwert auf ein Sprechen mit normaler Lautstärke hin ausgerichtet ist, bedeutet dies, dass die nun lautere Sprache als Nutzsignalkomponente von der Kompression erfasst wird, wodurch sich unerwünschterweise das Signal-zu-Rausch-Verhältnis verringert. Gleiches gilt für sonstigen Umgebungsschall oder direkten Audiosignalen aus Audioquellen, wobei ein an sich lautes Nutz- oder Zielsignal aus einem lärmenden, rauschenden oder sonstigen Hintergrundgeräusch herausgehört werden soll, wie z.B. das Signal eines einzelnen Musikinstruments oder dergleichen. Durch eine Kompression des aus dem Nutzsignal gewonnenen Audio-Signals oder eines das Nutzsignal direkt beinhaltenden Audio-Signals kann der Klang des Nutzsignals im komprimierten Audio-Signal als unnatürlich und sogar unangenehm empfunden werden. Besonders kann dies bei einem schnellen Einschwingen ("attack") und / oder Ausschwingen ("release") der Kompression gegeben sein.

Der Erfindung liegt daher die Aufgabe zugrunde, ein Verfahren zur Kompression der Dynamik in einem Audio-Signal anzugeben, welches möglichst flexibel auf unterschiedlich laute Umgebungen zu reagieren vermag und dabei insbesondere für klar definierbare Nutzsignale wie gesprochene Sprache einen möglichst natürlichen Klang aufweisen soll.

Die Aufgabe wird erfindungsgemäß gelöst durch ein Verfahren zur Kompression der Dynamik in einem Audio-Signal, wobei wenigstens ein Eingangspegel des Audio-Signals gemessen wird, wobei der gemessene Eingangspegel mit einem Grenzwert verglichen wird, wobei eine vorgegebene Kompressionscharakteristik mit einem durch einen Basiswert des Eingangspegels definierten Kniepunkt an das Audio-Signal angepasst wird, indem der Kniepunkt vom Basiswert auf einen demgegenüber höheren Zielwert angehoben wird, wenn der wenigstens eine Eingangspegel den Grenzwert überschreitet, und wobei das Audio-Signal gemäß der angepassten Kompressionscharakteristik komprimiert wird. Vorteilhafte und teils für sich gesehen erfinderische Ausgestaltungsformen sind Gegenstand der Unteransprüche und der nachfolgenden Beschreibung.

Insbesondere ist vorliegend unter einem Kniepunkt der Kompressionscharakteristik zu verstehen, dass für einen Eingangspegel bis zum Abszissenwert, welcher den Kniepunkt definiert, der Ausgangspegel durch den um einen konstanten Verstärkungsfaktor verstärkten Eingangspegel gegeben ist, und für Eingangspegel jenseits dieses Abszissenwertes die Verstärkung in Abhängigkeit vom Eingangspegel abnimmt. Hierbei ist insbesondere umfasst, dass die Kompressionscharakteristik jenseits des Kniepunktes ein selbst vom Eingangspegel abhängendes, ggf. abschnittweise konstantes Kompressionsverhältnis aufweist. Im vorliegenden Fall ist für die vorgegebene Kompressionscharakteristik der den Kniepunkt definierende Abszissenwert durch den Basiswert gegeben, der den Kniepunkt der angepassten Kompressionscharakteristik definierende Abszissenwert durch den Zielwert.

Die Erfindung geht dabei von der Überlegung aus, dass in einem zu verarbeitenden Audio-Signal insbesondere bei einem Nutzsignal mit einem merklichen Hintergrundrauschen, sonstigen Umgebungs- oder Zusatzgeräuschen oder Lärm, kurze Zeitkonstanten für das Einschwingen bzw. Ausschwingen ("attack" bzw. "release") bei einer starken Kompression, also der Kompression des Eingangspegels mit einem vergleichsweise hohen Kompressionsverhältnis, zu einem unnatürlichen oder gar unangenehmen Hörempfinden führen können. Auf einen kurzfristigen, vorübergehenden Anstieg des Pegels der Umgebungs- bzw. Hintergrundgeräusche reagiert ein Sprecher oftmals durch ein lauteres Sprechen. Soll nun in einer Umgebung, in welcher derartige Veränderungen des Pegels stattfinden können, ein Audio-Signal zur Weiterverarbeitung aufgezeichnet werden, dessen Nutzsignal durch gesprochene Sprache gebildet wird, weist der Eingangspegel erhebliche Variationen über einen breiten Dynamikbereich auf, welche insbesondere das Nutzsignal betreffen. Gleiches gilt adäquat für Musiksignale oder sonstige AudioSignale mit Nutz- oder Zielsignalen, deren Pegel große Variationen aufweisen.

Ist die Kompressionscharakteristik nun vorrangig für eine bestimmte Hör- bzw. Umgebungssituation ausgelegt, d.h., beginnt die Kompression im Sinne einer pegelabhängigen Abschwächung des Audio-Signals bei einem bestimmten voreingestellten Eingangspegel, welcher beispielsweise einem zu erwartenden Durchschnittswert für den Pegel des Nutzsignals entspricht oder knapp darüber gewählt wird, so führt dies zu einer unerwünschten stärkeren Kompression des Nutzsignals. Bei einer Beibehaltung der attack/release-Zeitkonstanten würde also pro Zeiteinheit das nun lautere Nutzsignal vergleichsweise stärker abgeschwächt, was aufgrund des resultierenden Hörempfindens eines fertig verarbeiteten Audio-Signals unerwünscht ist. Eine Anpassung an die stärkere Kompression des vorrübergehend höheren Eingangspegels durch eine Verlängerung der entsprechenden Zeitkonstanten könnte jedoch dazu führen, dass im Audio-Signal mit einem ohnehin erhöhten Eingangspegel kurze Pegelspitzen nicht mehr rechtzeitig abgefangen werden und somit durch die Verstärkung übersteuern können.

Die Erfindung schlägt demgegenüber vor, dass bei einer kurzfristigen, vorübergehenden Erhöhung des Eingangspegels eine vorgegebene Kompressionscharakteristik an diese Erhöhung angepasst wird, indem der Kniepunkt der Kompressionscharakteristik entsprechend zu einem höheren Wert für den Eingangspegel hin verschoben wird, und die Zeitkonstanten der Kompression selbst hierbei a priori nicht verändert werden. Um ein unnötiges Springen oder ein zu rasches Ansprechen der Anpassung zu verhindern, wird dabei der Eingangspegel mit einem entsprechend auszuwählenden Grenzwert verglichen, und die Anpassung erst bei einem Überschreiten des Grenzwertes vorgenommen. Bevorzugt wird hierbei für den Eingangspegel eines breitbandigen Eingangssignal ein Grenzwert zwischen 55 dB und 70 dB gewählt. Im Falle einer kanalabhängigen, also frequenzaufgelösten Betrachtung des Eingangssignals, wird im jeweiligen Kanal bevorzugt ein Grenzwert zwischen 40 dB und 55 dB gewählt. Die gewählten Grenzwerte entsprechen dabei insbesondere einer typischen Störlärmsituation.

In einer bevorzugten Variante wird der Kniepunkt auf einen vorbestimmten Zielwert angehoben. Der vorbestimmte Zielwert beruht hierbei auf Erfahrungswerten und ist insbesondere abhängig von einer gegebenen Hörsituation oder von einem gegebenen spezifischen Audio-Signal, wie beispielsweise einem Musiksignal, gewählt.

In einer anderen vorteilhaften Variante wird der Kniepunkt auf einen vom Eingangspegel abhängigen Zielwert angehoben wird. Hierbei wird der Eingangspegel, insbesondere über einen Zeitbereich gemittelt, erfasst. Ist der Grenzwert für den insbesondere gemittelten Eingangspegel überschritten, wird der Zielwert abhängig vom erfassten bzw. gemittelt erfassten Eingangspegel erhöht. Mit anderen Worten wird die Größe des Zielwerts, auf den der Kniepunkt angehoben wird, adaptiv dem aktuellen oder dem aktuell gemittelten Eingangspegel nachgeführt. Beispielsweise wird der Zielwert für den Kniepunkt dem mittleren Eingangspegel eines Pegelmessers nachgeführt, der ein langsames Ein- und Ausschwingverhalten hat. Dadurch lässt es sich in einer bevorzugten Ausgestaltung erreichen, dass die Kniepunkte in etwa 3 dB unter den Nutzsignal-relevanten Signalspitzen liegen.

Weiter kann eine Einregelzeit für den Vergleich des Eingangspegels mit dem Grenzwert derart gewählt oder eingestellt werden, dass extrem kurzzeitige Pegelspitzen, welche nicht von einer Erhöhung des generellen Geräuschpegels her rühren, nicht zu einer Anpassung der Kompressionscharakteristik führen, sondern der Vergleichsvorgang infolge der Einregelzeit zwar hinreichend rasch auf Veränderungen reagiert, diese jedoch von gewisser Dauer sein müssen, um die Anpassung auszulösen.

Günstigerweise wird bei einem Anheben des Kniepunktes der Kompressionscharakteristik zur Kompensation eine Gesamtverstärkung abgesenkt. Vorzugsweise wird die Gesamtverstärkung dabei derart abgesenkt, dass für den Eingangspegel, durch welchen der neuen Kniepunkt definiert ist, mittels der Absenkung der Gesamtverstärkung der Ausgangspegel im Vergleich zur ursprünglich vorgegebenen Kompressionscharakteristik bei diesem Eingangspegel erhalten bleibt. Hierdurch verändert sich die Wahrnehmung der Lautstärke nur für Eingangspegel, welche unterhalb des Kniepunktes liegen. Eine durch die Erhöhung des Kniepunkts für höhere durchschnittliche Lautstärken im Eingangspegel ausgelegte Kompressionscharakteristik wird demnach mittels der Absenkung der Gesamtverstärkung (lineare Anteil) zur Kompensation auf den durch die ursprünglich vorgegebene Kompressionscharakteristik bestimmten Dynamikverlauf abgebildet. Bevorzugt erfolgt die Absenkung der Gesamtverstärkung durch eine Verringerung des linearen Verstärkungsanteils in der Kompressionscharakteristik. Mit anderen Worten erfolgt im Vergleich zur ursprünglichen Charakteristik im Bereich niedriger Eingangspegel eine geringere Verstärkung, der Kniepunkt ist zu einem größeren Wert des Eingangspegels verschoben und im Bereich höherer Eingangspegel wird die ursprüngliche Verstärkung beibehalten. Dadurch, dass die Wahrnehmung der Lautstärke dabei für Eingangspegel jenseits des Zielwertes für den Kniepunkt erhalten bleibt, wird ein angenehmes Hörempfinden mit deutlich weniger Regelartefakten und geringerer Verstärkung des Umgebungslärms oder anderer unerwünschter Hintergrundgeräusche erreicht.

Bevorzugt wird der Kniepunkt zur Anpassung der Kompressionscharakteristik an das Audio-Signal auf den Basiswert abgesenkt, wenn nach einer Überschreitung des Grenzwertes der Eingangspegel den Grenzwert erneut unterschreitet. Hierdurch kann auf eine erneute Abnahme des durchschnittlichen Schallpegels von Stör- und Hintergrundgeräuschen im Umgebungsschall reagiert werden, so dass die Kompression an den jeweils relevanten Dynamikbereich angepasst bleibt. Insbesondere kann hierfür eine vorherige Absenkung einer Gesamtverstärkung zur Kompensation einer Anhebung des Kniepunktes der Kompressionscharakteristik rückgängig gemacht werden, und insbesondere kann für die Überprüfung der Unterschreitung eine Zeitkonstante herangezogen werden, so dass der Grenzwert erst dann als erneut unterschritten gilt, wenn nach einem Überschreiten der Eingangspegel für die volle Dauer der Zeitkonstante der Eingangspegel unterhalb des Grenzwertes bleibt.

Zweckmäßigerweise wird für die Kompression des Audio-Signals eine Zeitkonstante des Einschwingens ("attack") und/oder eine Zeitkonstante des Ausschwingens ("release") adaptiv in Abhängigkeit vom Eingangspegel bestimmt. Die adaptive Bestimmung der attack- und/oder release-Zeitkonstanten einer Kompression in Abhängigkeit vom Eingangspegel ermöglicht ein angenehmes Hörempfinden, da die Auswirkungen der Kompression auf den Nutzsignalanteil und ein Hintergrundrauschen im Audio-Signal gleichermaßen zu berücksichtigen sind, und ein sehr rasches Einschalten der Kompression oftmals als unnatürlich empfunden werden kann. Durch eine adaptive Bestimmung der attack- und/oder release-Zeitkonstanten kann für einen Signalanteil des Audio-Signals mit einem plötzlich auftretenden, sehr hohen Eingangspegel durch eine kurze Einschaltzeit ein Übersteuern oder eine Überverstärkung verhindert werden, bei einem mäßigen Ausschlag des Eingangspegels jedoch durch eine etwas längere Einschaltzeit ein natürlicherer Klang erhalten werden.

Als weiter vorteilhaft erweist es sich, wenn der Vergleich des gemessenen Eingangspegels mit dem Grenzwert eine längere Einregelzeit und/oder eine längere Ausregelzeit aufweist als die Zeitkonstante des Einschaltens bzw. die Zeitkonstante des Ausschaltens für die Kompression. Insbesondere kann dies bedeuten, dass für ein Überschreiten des Grenzwertes bzgl. der Einregelzeit gefordert wird, dass der Eingangspegel während der gesamten Einregelzeit über dem Grenzwert liegt.

Dadurch, dass für das Einschalten bzw. für das Ausschalten der Kompression eine kürzere Zeitkonstante gewählt wird als für den Vergleich des Eingangspegels mit dem Grenzwert, kann erreicht werden, dass sehr kurzfristige, schlagartige Veränderungen im Pegel des Signals, welches das Nutzsignal trägt, nicht zu einer Anpassung der Kompressionscharakteristik führen. Die Auswirkungen von derartigen Veränderungen in einem Ausgangssignal werden durch die Kompression selbst kontrolliert, wobei die kurzen Zeitkonstanten für das Einschalten bzw. das Ausschalten auch adaptiv bestimmt werden können und somit innerhalb bestimmter Intervalle eine gewisse Variation möglich sein kann. Ist jedoch ein Anstieg im Pegel des Signals von längerer Dauer, beispielsweise ein Sprechen in lauter werdender Umgebung, so ist möglicherweise davon auszugehen, dass auch das kurzfristige Dynamikverhalten und somit die Pegelausschläge, im vorliegenden Beispiel also u.a. Betonungen und Phrasierungen des Sprechers etc., dem Anstieg folgen, weswegen eine Anpassung der Kompressionscharakteristik in diesem Fall vorteilhaft ist.

In einer weiter vorteilhaften Ausgestaltung der Erfindung wird das Audio-Signal in eine Mehrzahl an Frequenzbändern zerlegt, wobei in einer Gruppe von Frequenzbändern für jedes Frequenzband der Gruppe jeweils ein Eingangspegel eines Signalanteils des Audio-Signals im Frequenzband gemessen wird, der gemessene Eingangspegel mit einem frequenzband-spezifischen Grenzwert verglichen wird, eine für das Frequenzband vorgegebene Kompressionscharakteristik an den Signalanteil angepasst wird, und der Signalanteil gemäß der angepassten Kompressionscharakteristik komprimiert wird. Insbesondere kann die Gruppe hierbei auch nur ein Frequenzband umfassen, so dass die beschriebene Anpassung der vorgegebenen Kompressionscharakteristik an den Signalanteil in Abhängigkeit vom Eingangspegel nur in einem Frequenzband durchgeführt wird, während in anderen Frequenzbändern eine derartige Anpassung ausbleibt. Die Anpassung kann jedoch auch für eine Mehrzahl an Frequenzbändern, insbesondere auch für alle Frequenzbänder des zerlegten Audio-Signals durchgeführt werden. Insbesondere kann hierbei der frequenzband-spezifische Grenzwert für den Eingangspegel und/oder die vorgegebene Kompressionscharakteristik für eine Mehrzahl an Frequenzbändern jeweils identisch sein.

Durch eine frequenzband-spezifische Anpassung der Kompressionscharakteristik können insbesondere bestimmte Signalanteile von üblichen oder je nach Hörsituation zu erwartenden Störgeräuschen in einzelnen Frequenzbändern sowie ihr Dynamikverhalten besser berücksichtigt werden. Insbesondere kann dabei auch die Anpassung frequenzband-spezifisch erfolgen, d.h., dass beispielsweise das Anheben des Kniepunkts in einzelnen Frequenzbändern auf jeweils unterschiedliche Zielwerte hin erfolgen kann. Insbesondere können für den Vergleich des Eingangspegels des Signalanteils im jeweiligen Frequenzband mit dem frequenzband-spezifischen Grenzwert auch die einzelnen Einregelzeiten und/oder Ausregelzeiten über die Frequenzbänder hinweg variieren. Die frequenzband-spezifische Anpassung der genannten Parameter erlaubt es, die vorhandenen Ressourcen wie Rechenleistung für ein möglichst realistisches Hörempfinden zu optimieren.

Die Erfindung nennt weiter eine Signalverarbeitungseinheit, umfassend einen Signaleingang zur Einspeisung eines Audio-Signals, welche dazu eingerichtet ist, das vorbeschriebene Verfahren durchzuführen. Die für das Verfahren und seine Weiterbildungen angegebenen Vorteile können hierbei sinngemäß auf die Signalverarbeitungseinheit übertragen werden. Insbesondere kann die Signalverarbeitungseinheit hierfür mit einem entsprechend eingerichteten Prozessor ausgerüstet sein, und/oder ein entsprechend komprimiertes Audio-Signal weiterverarbeiten und/oder an einem Signal-Ausgang ausgeben.

Die Erfindung nennt zudem ein Hörgerät, insbesondere ein Hörhilfegerät, umfassend wenigstens ein Mikrofon zur Gewinnung eines Audio-Signals aus einem Umgebungsschall, und eine mit dem Mikrofon verbundene Signalverarbeitungseinheit der vorbeschriebenen Art. Die durch die Signalverarbeitungseinheit im Hörgerät ermöglichte Kompression der Dynamik des Audio-Signals ist in einem Hörgerät insbesondere vor dem Hintergrund häufig wechselnder Hörsituationen mit unterschiedlicher Dynamik sowie der Anforderung an einen qualitativ möglichst hochwertigen, natürlichen Klang besonders vorteilhaft.

Nachfolgend wird ein Ausführungsbeispiel der Erfindung anhand einer Zeichnung näher erläutert. Hierbei zeigen jeweils schematisch:
- Fig. 1: in einem Blockdiagramm den Ablauf des Verfahrens zur Kompression der Dynamik in einem Audio-Signal,
- Fig. 2: in einem Pegeldiagramm die Kompressionscharakteristik, welche durch das Verfahren nach Fig. 1 angepasst wird, und
- Fig. 3: ein Hörhilfegerät.

Einander entsprechende Teile und Größen sind in allen Figuren jeweils mit gleichen Bezugszeichen versehen.

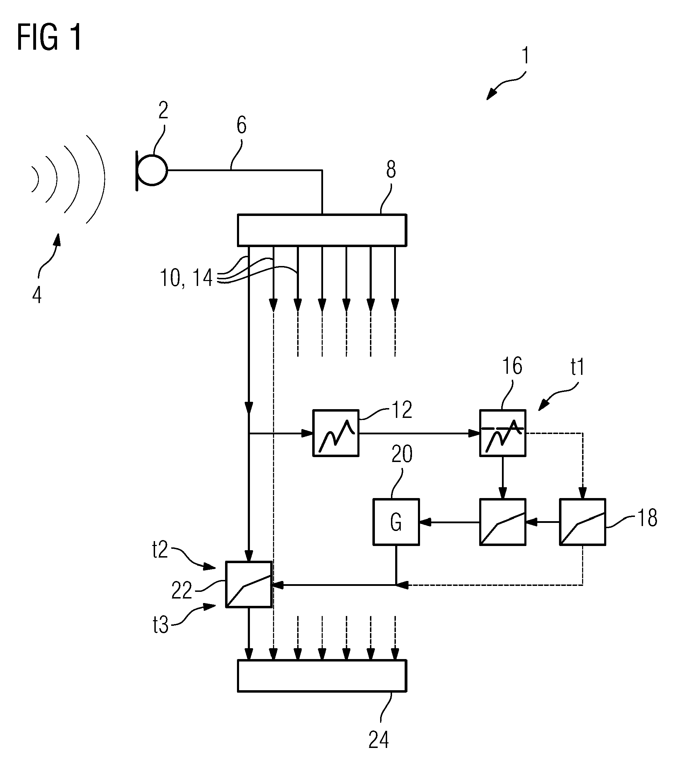

In Fig. 1 ist in einem Blockdiagramm schematisch der Ablauf eines Verfahrens 1 dargestellt. Ein Mikrofon 2 gewinnt aus einem Umgebungsschall 4, welcher durch ein nicht näher dargestelltes Sprachsignal gebildet wird, das von Lärm bzw. Rauschen überlagert ist, ein Audio-Signal 6. Alternativ liegt das Audio-Signal 6 als ein von einer Audioquelle direkt eingespieltes Signal, beispielsweise als ein Musiksignal vor, wobei das Nutzsignal (beispielsweise das Signal eines einzelnen Musikinstrument oder die Stimme des Interpreten) wiederum von Hintergrundgeräuschen überlagert ist. Das Audio-Signal 6 wird in einer Filterbank 8 in eine Mehrzahl an Frequenzbändern 10 zerlegt. In jedem einzelnen der Frequenzbänder 10 wird nun jeweils ein Eingangspegel 12 eines Signalanteils 14 des Audio-Signals 6 im Frequenzband 10 gemessen. Der Eingangspegel 12 des Signalanteils 14 wird mit einem für das Frequenzband 10 spezifisch vorgegebenen Grenzwert 16 verglichen, wobei für den Vorgang des Vergleichens eine Zeitkonstante t1 vorgesehen ist. Überschreitet nun der über der Zeitkonstanten t1 gemittelte Eingangspegel 12 den für das Frequenzband 10 vorgeschriebenen Grenzwert 16, so wird eine für das Frequenzband 10 vorgegebene Kompressionscharakteristik 18 in noch zu beschreibender Weise an den Signalanteil 14 des Audio-Signals 6 im Frequenzband 10 angepasst. Mit anderen Worten wird über die Zeitkonstante t1 die Anpassgeschwindigkeit für die Kompressionscharakteristik 18 festgelegt. Zusätzlich wird zur Kompensation dieser Anpassung der Kompressionscharakteristik 18 eine Gesamtverstärkung 20 im Frequenzband 10 abgesenkt. Der Signalanteil 14 des Audio-Signals 6 im Frequenzband 10 wird nun gemäß der so angepassten Kompressionscharakteristik 22 komprimiert. Die Zeitkonstante t2 für das Einschwingen sowie die Zeitkonstante t3 für das Ausschwingen der Kompression gemäß der angepassten Kompressionscharakteristik sind hierbei insbesondere kürzer gewählt als die Zeitkonstante t1 für den Vergleich des Eingangspegels 12 mit dem Grenzwert 16.

Wird durch den im Frequenzband 10 gemessenen Eingangspegel 12 des Signalanteils 14 der Grenzwert 16 nicht überschritten, oder nur für einen Zeitraum erheblich kürzer als die Zeitkonstante t1 überschritten, so wird die für das Frequenzband 10 vorgegebene Kompressionscharakteristik 18 unverändert als die an den Signalanteil 14 angepasste Kompressionscharakteristik 22 definiert, und der Signalanteil14 entsprechend gemäß der angepassten Kompressionscharakteristik 22 komprimiert. Gleiches geschieht, wenn nach einem vorherigen Überschreiten des Grenzwerts 16 durch den Eingangspegel 12 des Signalanteils 14 der frequenzband-spezifische Grenzwert 16 erneut für einen Zeitraum, welcher länger ist als durch die Zeitkonstante t1 vorgegeben, unterschritten wird.

Im Diagramm ist die Anpassung der Kompressionscharakteristik 18 exemplarisch für eines der Frequenzbänder 10 dargestellt. Nach der Kompression gemäß der angepassten Kompressionscharakteristik 22 können die einzelnen Signalanteile 14 der Frequenzbänder 10 einem weiteren Signalverarbeitungsblock 24 zugeführt werden, in welchem die Signalanteile 14 des Audio-Signals 6 frequenzband-spezifisch oder breitbandig weiter verarbeitet werden. Der Signalverarbeitungsblock 24 kann dabei beispielsweise Verfahren zur Rauschunterdrückung umfassen.

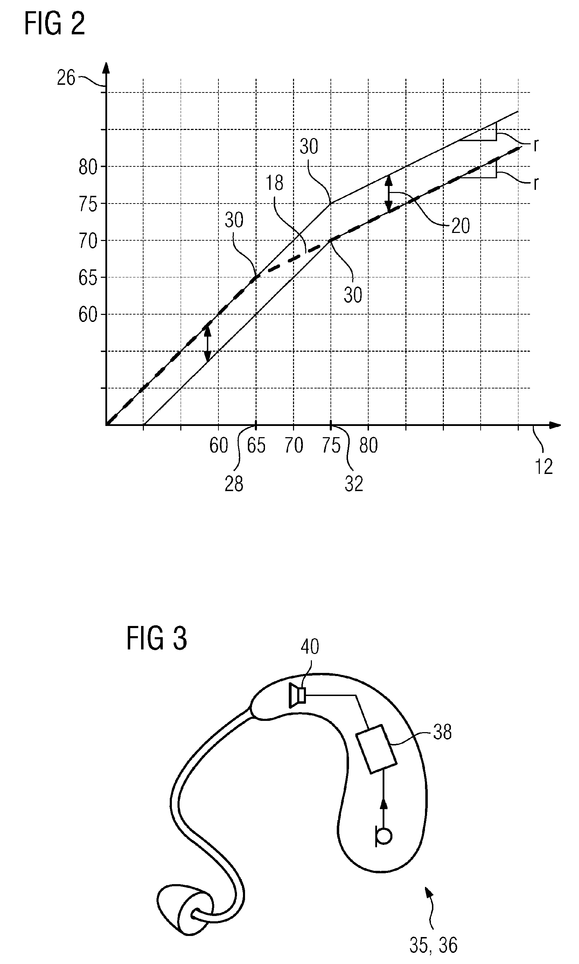

In Fig. 2 ist in einem Pegeldiagramm eine beispielhafte Anpassung einer Kompressionscharakteristik 18,22 durch das Verfahren nach Fig. 1 dargestellt. Der durch die Kompression resultierende Ausgangspegel 26 ist hier gegen den Eingangspegel 12 aufgetragen. Die gestrichelte Kennlinie entspricht der ursprünglich für ein breitbandiges Audio-Signal 6 vorgegebenen Kompressionscharakteristik 18 für den Fall, dass der Eingangspegel 12 den vorgegebenen Grenzwert 16 nicht überschreitet. Die vorgegebene Kompressionscharakteristik 18 weist hierbei bis zu einem Basiswert 28 für den Eingangspegel, welcher im vorliegenden Fall bei einem Wert von 65 dB liegt, einen linearen Verlauf mit einer konstanten Verstärkung um den Verstärkungsfaktor 1 auf. Das bedeutet, dass ein Signalanteil im Audio-Signal 6, dessen Eingangspegel 65 dB nicht überschreitet, durch den Kompressionsblock in einer Signalverarbeitung identisch weitergegeben wird.

Durch den Basiswert 28 für den Eingangspegel 12 ist der Kniepunkt 30 der Kompressionscharakteristik 18 definiert. Signalanteile mit einem Eingangspegel 12 größer als 65 dB werden in Abhängigkeit des Eingangspegels mit einem Kompressionsverhältnis von r = ½ abgeschwächt, wodurch die Kompressionscharakteristik 18 beim Kniepunkt 30 abknickt. Die in Fig. 1 dargestellte Anpassung der Kompressionscharakteristik 18 an den Eingangspegel 12 des Signalanteils 14 sieht nun zunächst vor, bei einem Überschreiten des Grenzwertes 16 durch den erfassten und insbesondere gemittelten Eingangspegel 12 die Kompression mit r = ½ erst für höhere Werte des Eingangspegels 12 zu aktivieren, als es der Basiswert 28 vorsieht. Hierzu wird der Kniepunkt 30 vom Basiswert 28 auf einen Zielwert 32 angehoben, welcher im vorliegenden Fall 75 dB beträgt. Dies bedeutet, dass nun für Signalanteile mit einem Eingangspegel 12 von bis zu 75 dB keine Kompression stattfindet, sondern diese erst für einen Eingangspegel oberhalb von 75 dB aktiviert wird, und entsprechend Signalanteile 14 in einer ähnlichen Abhängigkeit vom Eingangspegel 12 komprimiert werden, wie es die Kennlinie der Kompressionscharakteristik 18 vorsieht. Diese Abhängigkeit ist im Diagramm durch die gepunktete Linie dargestellt.

Da durch die Verschiebung des Kniepunktes 30 zu einem höheren Zielwert 32 für den Eingangspegel 12 effektiv für einen Eingangspegel 12 oberhalb des Basiswerts 28 die Signalleistung ansteigt, wird zur Kompensation die Gesamtverstärkung 20 dahingehend abgesenkt, dass die Kennlinie der angepassten Kompressionscharakteristik 22, welche im Diagramm durch eine durchgezogene Linie dargestellt ist, für Werte des Eingangspegels 12 oberhalb des Zielwertes 32 mit der Kennlinie der vorgegebenen Kompressionscharakteristik 18 übereinstimmt. Dies führt dazu, dass in einer Hörsituation, in welcher ein Umgebungsschall 4 gesprochene Sprache als ein Nutzsignal trägt, welches von lauten Störgeräuschen überlagert wird, ein ähnliches Signal-zu-Rausch-Verhältnis aufweisen kann, wie ein vergleichbares Nutzsignal in einer weniger lauten Umgebung.

Durch das Absenken der Gesamtverstärkung 20, im vorliegenden Fall um 5 dB, werden in der angepassten Kompressionscharakteristik 22 Signalanteile mit einem Eingangspegel 12 unterhalb des Basiswerts 28 von 65 dB im Vergleich zur vorgegebenen Kompressionscharakteristik 18 entsprechend um 5 dB abgesenkt. Im Übergangsbereich zwischen dem Basiswert 28 und dem Zielwert 32 für den Eingangspegel 12 fällt diese Absenkung verglichen zur vorgegebenen Kompressionscharakteristik 18 entsprechend geringer aus. Da jedoch angenommen wird, dass diese Absenkung vorrangig Störgeräusche und Hintergrundrauschen aus der Umgebung betrifft, jedoch nicht das Nutzsignal, kann somit eine Verbesserung des Signal-zu-Rausch-Verhältnisses erzielt werden.

Als Grenzwert 16 für ein breitbandiges Audio-Signal 6 entsprechend Fig. 2, ab dem eine insbesondere adaptive Anpassung der Kompressionscharakteristik 22 vorgenommen wird, werden beispielsweise 70 dB gewählt. Die adaptive Anpassung erfolgt beispielsweise dadurch, dass der Zielwert 32 abhängig vom gemessenen, insbesondere also gemittelten, Wert des Eingangspegels 12 gewählt wird. Beispielsweise wird der Zielwert für den Kniepunkt dem mittleren Eingangspegel eines Pegelmessers nachgeführt, der ein langsames Ein- und Ausschwingverhalten hat. Dadurch ist bevorzugt erreicht, dass die Kniepunkte in etwa 3 dB unter den Nutzsignal-relevanten Signalspitzen liegen.

In Fig. 3 ist ein Hörgerät 35 dargestellt, welches als Hörhilfegerät 36 ausgebildet ist. Das Hörhilfegerät 36 umfasst ein Mikrofon 2 zur Gewinnung eines Audio-Signals 6 aus einem Umgebungsschall 4, eine mit dem Mikrofon 2 verbundene Signalverarbeitungseinheit 38, in welche das Audio-Signal 6 eingespeist wird, und einen mit der Signalverarbeitungseinheit 38 verbundenen Lautsprecher 40. Die Signalverarbeitungseinheit 38 ist dabei insbesondere dazu eingerichtet, das Audio-Signal 6, welches vom Mikrofon 2 aus einem Umgebungsschall 4 gewonnen wurde, in Abhängigkeit des Eingangspegels gemäß des vorgeschriebenen Verfahrens zu komprimieren, und ein entsprechend komprimiertes Ausgangssignal zur Wiedergabe an den Lautsprecher 40 weiterzugeben.

Obwohl die Erfindung im Detail durch das bevorzugte Ausführungsbeispiel näher illustriert und beschrieben wurde, ist die Erfindung nicht durch dieses Ausführungsbeispiel eingeschränkt. Andere Variationen können vom Fachmann hieraus abgeleitet werden, ohne den Schutzumfang der Erfindung zu verlassen.

### Bezugszeichenliste

- 1: Verfahren
- 2: Mikrofon
- 4: Umgebungsschall
- 6: Audio-Signal
- 8: Filterbank
- 10: Frequenzband
- 12: Eingangspegel
- 14: Signalanteil
- 16: Grenzwert
- 18: vorgegebene Kompressionscharakteristik
- 20: Gesamtverstärkung
- 22: angepasste Kompressionscharakteristik
- 24: Signalverarbeitungsblock
- 26: Ausgangspegel
- 28: Basiswert
- 30: Kniepunkt
- 32: Zielwert
- 35: Hörgerät
- 36: Hörhilfegerät
- 38: Signalverarbeitungseinheit
- 40: Lautsprecher

- r: Kompressionsverhältnis
- t1: Zeitkonstante für Vergleich mit Grenzwert
- t2: Zeitkonstante für Einschalten ("attack") der Kompression
- t3: Zeitkonstante für Ausschalten ("attack") der Kompression

## Patentansprüche

1. Verfahren (1) zur Kompression der Dynamik in einem Audio-Signal (6), wobei wenigstens ein Eingangspegel (12) des Audio-Signals (6) gemessen wird, wobei der gemessene Eingangspegel (12) mit einem Grenzwert (16) verglichen wird,
wobei eine vorgegebene Kompressionscharakteristik (18) mit einem durch einen Basiswert (28) des Eingangspegels (12) definierten Kniepunkt (30) an das Audio-Signal (6) angepasst wird, indem der Kniepunkt (30) vom Basiswert (28) auf einen höheren Zielwert (32) angehoben wird, wenn der wenigstens eine Eingangspegel (12) den Grenzwert (16) überschreitet, und
wobei das Audio-Signal (6) gemäß der angepassten Kompressionscharakteristik (22) komprimiert wird.

2. Verfahren (1) nach Anspruch 1,
wobei bei einem Anheben des Kniepunktes (30) der Kompressionscharakteristik (18) zur Kompensation eine Gesamtverstärkung (20) abgesenkt wird.

3. Verfahren (1) nach Anspruch 1 oder 2,
wobei der Kniepunkt (30) auf einen vorbestimmten Zielwert (32) angehoben wird.

4. Verfahren (1) nach Anspruch 1 oder 2,
wobei der Kniepunkt (30) auf einen vom Eingangspegel abhängigen Zielwert (32) angehoben wird.

5. Verfahren (1) nach einem der vorhergehenden Ansprüche,
wobei der Kniepunkt (30) zur Anpassung der Kompressionscharakteristik (18) an das Audio-Signal (6) auf den Basiswert (28) abgesenkt wird, wenn nach einer Überschreitung des Grenzwertes (16) der Eingangspegel (12) den Grenzwert (16) erneut unterschreitet.

6. Verfahren (1) nach einem der vorhergehenden Ansprüche,
wobei für die Kompression des Audio-Signals (6) eine Zeitkonstante des Einschaltens (t2) und/oder eine Zeitkonstante des Ausschaltens (t3) adaptiv in Abhängigkeit vom Eingangspegel (12) bestimmt wird.

7. Verfahren (1) nach einem der vorhergehenden Ansprüche,
wobei der Vergleich des gemessenen Eingangspegels (12) mit dem Grenzwert (16) eine längere Einregelzeit (t1) und/oder eine längere Ausregelzeit (t1) aufweist als die Zeitkonstante des Einschaltens (t2) bzw. die Zeitkonstante des Ausschaltens (t3) für die Kompression.

8. Verfahren (1) nach einem der vorhergehenden Ansprüche,
wobei das Audio-Signal (6) in eine Mehrzahl an Frequenzbändern (10) zerlegt wird,
wobei in einer Gruppe von Frequenzbändern (10) für jedes Frequenzband (10) der Gruppe jeweils
- ein Eingangspegel (12) eines Signalanteils (14) des Audio-Signals (6) im Frequenzband (10) gemessen wird,
- der gemessene Eingangspegel (12) mit einem frequenzband-spezifischen Grenzwert (16) verglichen wird,
- eine für das Frequenzband (10) vorgegebene Kompressionscharakteristik (18) an den Signalanteil (14) angepasst wird, und
- der Signalanteil (14) gemäß der angepassten Kompressionscharakteristik (22) komprimiert wird.

9. Signalverarbeitungseinheit (38), umfassend einen Signaleingang zur Einspeisung eines Audio-Signals (6), welche dazu eingerichtet ist, ein Verfahren (1) nach einem der vorhergehenden Ansprüche durchzuführen.

10. Hörgerät (35), insbesondere Hörhilfegerät (36), umfassend wenigstens ein Mikrofon (2) zur Gewinnung eines Audio-Signals (6) aus einem Umgebungsschall (4), und eine mit dem Mikrofon (2) verbundene Signalverarbeitungseinheit (38) nach Anspruch 9.
